# EUROPÄISCHE PATENTANMELDUNG

(11) **EP 4 325 233 A1**
(43) Veröffentlichungstag der Anmeldung: **21.02.2024**
(21) Anmeldenummer: 23191792.3
(22) Anmeldetag: 16.08.2023
(51) Int. Cl.: G01R 33/00, G01R 33/07, G01R 33/09, G01D 5/14

(54) **VERFAHREN ZUM HERSTELLEN EINES MAGNETFELDSENSORCHIPS MIT EINEM INTEGRIERTEN BACK-BIAS MAGNETEN**

(30) Priorität: 18.08.2022 DE 102022208562
(71) Anmelder: Fraunhofer-Gesellschaft zur Förderung der angewandten Forschung e.V., 80686 München (DE)
(72) Erfinder: LISEC, Thomas, 25524 Itzehoe (DE); GOJDKA, Björn, 22524 Itzehoe (DE); Hohe, Hans-Peter, 91058 Erlangen (DE); Cichon, Daniel, 91058 Erlangen (DE); Stahl-Offergeld, Markus, 91058 Erlangen (DE)
(74) Vertreter: Fischer, Florian

(57) **Zusammenfassung**

Die vorliegende Offenbarung beschreibt ein Verfahren zum Herstellen eines Magnetfeldsensorchips (200) mit einem integrierten Back-Bias Magneten (140). Es wird ein Substrat (100) mit einer ersten Substratoberfläche (101) und einer gegenüberliegenden zweiten Substratoberfläche (102) bereitgestellt, wobei auf der ersten Substratoberfläche (101) mindestens ein Magnetfeldsensor (110) angeordnet wird. In der zweiten Substratoberfläche (102) wird eine Kavität (120) strukturiert. Das Verfahren beinhaltet das Erzeugen des integrierten Back-Bias Magneten (140) innerhalb der ersten Kavität (120) durch Einbringen von, magnetisches Material aufweisendem, losem Pulver (160) in die erste Kavität (102) und Agglomerieren des Pulvers (160) zu einer mechanisch festen Magnetkörperstruktur mittels Atomlagenabscheidung. Erfindungsgemäß wird der Schritt des Erzeugens des Back-Bias Magneten (140) zeitlich nach dem Schritt des Anordnens des Magnetfeldsensors (110) ausgeführt.

## Beschreibung

Das hierin beschriebene innovative Konzept betrifft einen miniaturisierten Magnetfeldsensorchip sowie ein Verfahren zum Herstellen eines Magnetfeldsensorchips. Der Magnetfeldsensorchip weist ein Substrat auf, auf dem mindestens ein Magnetfeldsensor angeordnet ist. Außerdem ist in dem Magnetfeldsensorchip mindestens ein Back-Bias Magnet integriert.

Magnetfeldsensoren werden in nahezu allen Bereichen der Technik eingesetzt. Im Unterschied zu Anwendungen wie Navigation und Kompass, die auf der Bestimmung des natürlichen Magnetfelds der Erde beruhen, werden für die Detektion von Bewegung, Geschwindigkeit oder Position in Anlagen und Geräten Permanentmagnete genutzt, deren Magnetfeld detektiert und deren relative Lage zum Sensor auf diese Weise überwacht werden kann. Alternativ kann auch ein weichmagnetischer Körper, z. B. ein Zahnrad aus Stahl, überwacht werden, wenn durch dessen Bewegung ein Magnetfeld moduliert wird.

Dieses Magnetfeld, auch Back-Bias genannt, wird durch einen Back-Bias Permanentmagneten bereitgestellt, der mit dem Sensor fest verbunden ist. Aktuell werden für Back-Bias konventionell hergestellte Permanentmagnete verwendet, deren Abmessungen 1 mm übersteigen und die gemeinsam mit dem Sensor im gleichen Gehäuse, d.h. hybrid, montiert werden. Im Vergleich zu den Sensorelementen, die in Mikrostrukturierungstechnik gefertigt werden können, nimmt der Permanentmagnet den weitaus größten Teil des Gehäuses ein.

Bei herkömmlichen Magnetfeldsensoren sind die aktiven Sensorflächen (z.B. Hallplatten) im Abstand von 2 bis 3 mm angeordnet. Da die Sensorflächen in Bereichen gleicher Magnetfeldstärke liegen sollten, muss der Back-Bias Magnet daher ausreichend breit sein, um dies zu gewährleisten und Justage-Toleranzen ausgleichen zu können. Da die Feldstärke außerdem vom Aspektverhältnis des Magneten abhängt, ist bei vertikaler Magnetisierung gleichzeitig eine gewisse Mindesthöhe des Magneten erforderlich, um eine bestimmte magnetische Flussdichte im Bereich der Sensorflächen bereitzustellen.

Die DE 10 2011 114 773 B4 beschreibt ein Verfahren zur Miniaturisierung des Back-Bias Magneten. Unter Anwendung von Halbleitertechnologie-Verfahren werden Pyramidenformen mit hoher Positionsgenauigkeit direkt auf der Rückseite des Sensorchips, z.B. durch anisotropes Ätzen, erzeugt. Der Magnet wird anschließend, z.B. durch Auftragen eines mit Magnetpartikeln gefüllten Polymers, auf Substratebene hergestellt. Mittels eines Magnetfeldkonzentrators auf der Vorderseite, z. B. einer Planarspule mit Kern, wird das Magnetfeld im Bereich der Sensorelemente noch zusätzlich konzentriert bzw. verstärkt.

Die Herstellung der Back-Bias Magneten auf Substratebene senkt die Kosten und erhöht die Ausbeute. In der EP 0 244 737 B1 wird aus diesem Grund eine mit Ferrit-Partikeln gefüllte Polymerschicht auf die plane Substratrückseite aufgebracht und anschließend wird das Substrat in Chips vereinzelt. Nachdem der Chip im Sensorgehäuse eingeklebt und mittels Drahtbonden elektrisch kontaktiert wurde, wird auf die Oberseite des Chips durch Aufbringen eines mit Ferrit-Partikeln gefüllten Polymers ein weiterer Magnet erzeugt.

Die auf Substratebene erzeugten Back-Bias Magnete können geformt werden, indem das mit Magnetpartikeln gefüllte Polymer, z.B. mittels Siebdruck, aufgebracht wird, so wie es in der EP 1 989 564 B1 beschrieben ist.

Statt Siebdruck wird in der US 2011 0 151 587 A1 eine mittels lithographischer Verfahren der Halbleitertechnologie hergestellte Lackmaske als Form (Mold) verwendet, in die das mit Magnetpartikeln gefüllte Polymer (Magnetpaste), z.B. mittels Rakeln, eingebracht wird. Nach dem Aushärten des Polymers wird die Lackmaske selektiv dazu wieder entfernt, so dass freistehende magnetische Strukturen auf der Substratoberfläche verbleiben.

Die auf Substratebene erzeugten Magnete ermöglichen sehr platzsparende Bauformen, sodass die entsprechenden Magnetfeldsensoren in sehr kompakten Komponenten eingesetzt werden können. Für Bauelemente, wie sie in der oben genannten US 2011 0 151 587 A1 beschrieben sind, werden z.B. Katheter als eine mögliche Anwendung genannt. Mittels Siebdrucks oder Rakeln können jedoch nur relativ flache Magnetstrukturen präzise hergestellt werden. Da die Stärke eines Magneten jedoch proportional mit dessen Volumen ansteigt, können derartige Magnete unter Umständen keine ausreichend starken Magnetfelder für Back-Bias Sensoranordnungen bereitstellen.

Daher wäre es wünschenswert, Back-Bias Magnete herzustellen, die trotz einer miniaturisierten Bauform ein ausreichend starkes Magnetfeld erzeugen, um Back-Bias Magnetfeldsensoren damit zu betreiben. Abgesehen davon wäre es wünschenswert, dass die Herstellung der Back-Bias Magnete kostengünstig ist und gleichzeitig mit der Erzeugung benachbarter integrierter Sensorschaltungen kompatibel ist.

Dies wird ermöglicht mit einem erfindungsgemäßen Verfahren zum Herstellen eines Magnetfeldsensorchips mit einem integrierten Back-Bias Magneten. Ein Verfahrensschritt beinhaltet das Bereitstellen eines Substrats mit einer ersten Substratoberfläche und einer gegenüberliegenden zweiten Substratoberfläche. Ein weiterer Verfahrensschritt beinhaltet das Anordnen von mindestens einem Magnetfeldsensor auf der ersten Substratoberfläche sowie ein Strukturieren von mindestens einer ersten Kavität in der zweiten Substratoberfläche. Ein weiterer Verfahrensschritt beinhaltet das Erzeugen des integrierten Back-Bias Magneten innerhalb der ersten Kavität durch Einbringen von losem Pulver aus magnetischem Material in die erste Kavität, und Agglomerieren des Pulvers zu einer mechanisch festen Magnetkörperstruktur mittels Atomlagenabscheidung. Dadurch, dass der Back-Bias Magnet in dem gleichen Substrat integriert wird auf dem auch der Magnetfeldsensor angeordnet ist, kann der Abstand zwischen dem Back-Bias Magneten und dem Magnetfeldsensor, im Vergleich zu einer hybriden Montage, deutlich reduziert werden. Dadurch wirkt ein sehr homogenes Magnetfeld am Ort des Sensors und die Magnetfeldstärke am Sensor ist trotz des miniaturisierten Back-Bias Magneten ausreichend groß, um den Sensor zu durchsetzen. Erfindungsgemäß wird der Schritt des Erzeugens des Back-Bias Magneten zeitlich nach dem Schritt des Anordnens des Magnetfeldsensors ausgeführt. In anderen Worten kann der Back-Bias Magnet also zeitlich nach der vollständigen Realisierung des Magnetfeldsensors, einschließlich optional vorhandener integrierter Schaltkreise, erzeugt werden, sodass der Herstellungsprozess des Magnetfeldsensors bzw. der Schaltkreise nicht eingeschränkt wird. Die Kavität wird vorzugsweise mittels Mikrostrukturierungstechniken, z.B. mittels eines Ätzprozesses, in das Substrat eingebracht. Diese Mikrostrukturierungstechniken sind sehr exakt steuerbar, sodass die Position der Kavität im Substrat mit einer Genauigkeit im Mikrometerbereich festgelegt werden kann. Dadurch kann der innerhalb der Kavität zu erzeugende Back-Bias Magnet hochpräzise gegenüber dem Magnetfeldsensor ausgerichtet werden. Ein weiterer Vorteil der in Mikrostrukturierungstechnik gefertigten Kavitäten besteht darin, dass mit sehr hoher Präzision Kavitäten mit unterschiedlichen geometrischen Formen realisiert werden können. Dementsprechend weisen auch die in den entsprechend geformten Kavitäten erzeugten Back-Bias Magnete eine solche hochpräzise geometrische Form auf. Beispielsweise kann eine solche geometrische Form derart gewählt werden, dass der Verlauf der Magnetfeldlinien der Back-Bias Magnete dadurch gezielt beeinflusst werden kann. Zum Beispiel können die Magnetfeldlinien derart beeinflusst werden, dass ein möglichst homogener und/oder konzentrierter Magnetfluss durch den Magnetfeldsensor stattfindet. Es kann also ein anwendungsspezifisches "Shaping" des Magnetfelds realisiert werden.

Die vorliegende Erfindung betrifft ferner einen Magnetfeldsensorchip mit integriertem Back-Bias Magnet, der unter Anwendung des oben beschriebenen Verfahrens hergestellt wurde.

Weitere Ausführungsformen und vorteilhafte Aspekte dieses Verfahrens zum Herstellen eines Magnetfeldsensorchips mit einem integrierten Back-Bias Magneten sind in den jeweils abhängigen Patentansprüchen genannt.

Einige Ausführungsbeispiele sind exemplarisch in der Zeichnung dargestellt und werden nachstehend erläutert. Es zeigen:
- Figs. 1A-1G: schematische Ansichten unterschiedlicher Magnetfeldsensoren mit Back-Bias Magneten gemäß dem Stand der Technik,
- Figs. 2A-2C: eine schematische Ansicht einzelner Verfahrensschritte zum Herstellen eines erfindungsgemäßen Magnetfeldsensorchips gemäß einem Ausführungsbeispiel,
- Figs. 3A-3C: eine schematische Ansicht einzelner Verfahrensschritte zum Herstellen eines erfindungsgemäßen Magnetfeldsensorchips gemäß einem weiteren Ausführungsbeispiel,
- Figs. 4A-4C: schematische Darstellungen zum Erzeugen erfindungsgemäßer Mikrokörperstrukturen mittels Agglomeration von losen Partikeln unter Anwendung eines ALD-Verfahrens gemäß Ausführungsbeispielen der Erfindung,
- Fig. 5A: eine Perspektivansicht auf eine Messanordnung mit einem erfindungsgemäßen Magnetfeldsensorchip 200 und einem weichmagnetischen Geberrad,
- Fig. 5B: einen beispielhaften Signalverlauf der gemessenen Magnetfeldkoponenten in X-, Y- und Z-Richtung,
- Fig. 6A: eine schematische Ansicht eines erfindungsgemäßen Magnetfeldsensorchips mit ringförmigen integrierten Back-Bias Magneten gemäß einem Ausführungsbeispiel,
- Fig. 6B: eine schematische Ansicht eines erfindungsgemäßen Magnetfeldsensorchips mit einzelnen integrierten Back-Bias Magneten gemäß einem Ausführungsbeispiel,

- Figs. 7A, 7B: eine schematische Ansicht eines erfindungsgemäßen Magnetfeldsensorchips mit ringförmigen integrierten Back-Bias Magneten und weichmagnetischen Mikrokernen gemäß einem Ausführungsbeispiel, und
- Fig. 8: eine schematische Ansicht zur Visualisierung der Auswirkungen zeitgesteuerter Ätzprozesse auf die zu strukturierenden Kavitäten und die darin zu erzeugenden Mikrokörperstrukturen und Back-Bias Magnete.

Im Folgenden werden Ausführungsbeispiele mit Bezug auf die Figuren näher beschrieben, wobei Elemente mit derselben oder ähnlichen Funktion mit denselben Bezugszeichen versehen sind.

Verfahrensschritte, die im Rahmen der vorliegenden Offenbarung abgebildet bzw. beschrieben sind, können auch in einer anderen als der abgebildeten beziehungsweise beschriebenen Reihenfolge ausgeführt werden. Außerdem sind Verfahrensschritte, die ein bestimmtes Merkmal einer Vorrichtung betreffen mit ebendiesem Merkmal der Vorrichtung austauschbar, was ebenso anders herum gilt.

Sofern innerhalb dieser Offenbarung von einer Kompensation, insbesondere von einer Kompensation von prozessbedingten Unterschieden von Magnetfeldcharakteristiken einzelner Back-Bias Magnete, die Rede ist, dann ist hierunter ein Abschwächen bzw. Reduzieren von Messabweichungen zu verstehen, die auf die unterschiedlichen Magnetfeldcharakteristiken zurückzuführen sind. Bei einer hierin beschriebenen Kompensation handelt es sich demnach um ein Abschwächen bzw. Reduzieren eines durch die prozessbedingt unterschiedlichen Magnetfeldcharakteristiken hervorgerufenen Messfehlers (gegenüber identischen Magnetfeldern). Unter dem Begriff der Kompensation kann ein Reduzieren des Messfehlers auf bis zu ≤ 10% Abweichung verstanden werden, bis hin zu einem vollständigen Reduzieren bzw. Auslöschen des Messfehlers.

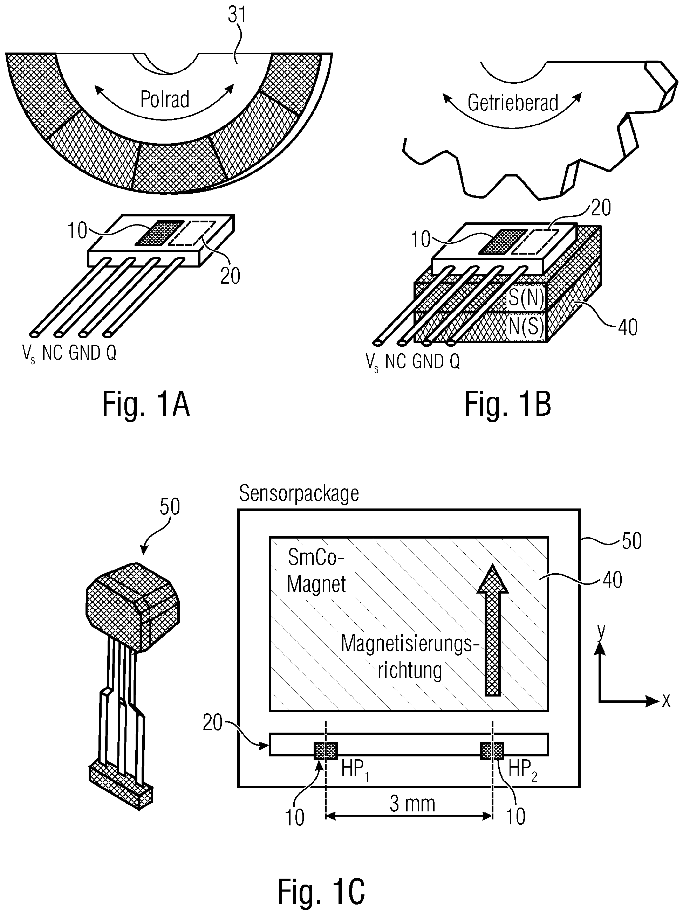

Einleitend sollen zunächst konventionelle Magnetfeldsensoren gemäß dem Stand der Technik und deren Anwendungsmöglichkeiten beschrieben werden. Hierzu sei auf die Figuren 1A bis 1G verwiesen.

Figur 1A zeigt eine schematische Darstellung der Messung der Drehgeschwindigkeit einer Achse mittels eines Hall-Sensors 10, einschließlich zugehöriger Sensorschaltung 20, in Kombination mit einem Polrad 31. Figur 1B zeigt die gleiche Messung, allerdings mittels eines Hall-Sensors 10 mit Back-Bias Magnet 40, in Kombination mit einem weichmagnetischen Geberrad 32.

Die Figuren 1A und 1B illustrieren also die Verwendung von Magnetfeld-Sensoren 10 am Beispiel der Überwachung einer Drehbewegung. Ein Sensor 10 in Kombination mit einem Polrad 31 (encoder wheel) mit gegenläufig magnetisierten Polfeldern, wie in Figur 1A dargestellt [1], erlaubt die präzise Bestimmung von Achsposition, Drehwinkel und Drehgeschwindigkeit.

Im Falle eines Sensors 10 mit Back-Bias Magnet 40 (Figur 1B) wird statt des Polrades 31 ein im Getriebe vorhandenes (weichmagnetisches) Zahnrad 32 überwacht. Die Bewegung der Zähne verursacht eine periodische Modulation (z.B. Verzerrung) des durch den Back-Bias-Magneten 40 bereitgestellten Feldes, die vom Sensor 10 detektiert wird. Die Genauigkeit der Positionsbestimmung ist zwar geringer als im Falle des Polrades 31, jedoch sind auch die Kosten eines Zahnrads 32 (Figur 1B) deutlich geringer gegenüber einem Polrad 31 (Figur 1A).

Figur 1C zeigt ein Sensorpackage 50 mit einem Hall-Sensor 10 und einem in dem Package 50 angeordneten Back-Bias-Magneten 40. Der abgebildete schematische Querschnitt (rechts) lässt erkennen, dass der Magnet 40 den weitaus größten Teil des Gehäuses bzw. Packages 50 einnimmt. Die Hall-Sensor-Schaltung 20 hat zwei aktive Sensorflächen (HallPlatten) 10 im Abstand von 3 mm, die in Bereichen gleicher Magnetfeldstärke liegen sollten. Der Back-Bias Magnet 40 muss daher ausreichend breit sein, um dies zu gewährleisten, und darüber hinaus auch Justage-Toleranzen ausgleichen zu können.

Da die Feldstärke vom Aspekt-Verhältnis des Magneten 40 abhängt, ist bei vertikaler Magnetisierung gleichzeitig eine gewisse Mindesthöhe erforderlich, um eine bestimmte magnetische Flussdichte im Bereich der Sensorflächen 10 bereitstellen zu können.

Da die hier zum Einsatz kommenden Back-Bias-Magnete 40 für Gewöhnlich aus Materialien wie SmCo oder NdFeB bestehen, bedingt dessen Größe entsprechend große Mengen an wertvollen Ressourcen (Selten-Erden-Metallen). Um die Mengen zu reduzieren, könnten zwei kleinere Magnete anstatt eines großen Magneten verwendet werden. Jedoch steigen dadurch die Kosten nicht nur durch einen erhöhten Montagaufwand. Die Fertigung kleinster Magnete aus SmCo oder NdFeB mit Kantenlängen unter 1 mm wird zunehmend aufwendig und teuer. Es sind Mikromagnete bekannt, die mittels Präzisions-Laserbearbeitung hergestellt werden. Diese werden zu Kleinstmengen-Preisen von ca. 10 Euro pro Stück angeboten [4], was jedoch für eine Großserienproduktion einen unverhältnismäßig hohen Kostenaufwand darstellt.

Die Größe des Back-Bias-Magneten 40 steht des Weiteren in Diskrepanz zur Größe der aktiven Sensorfläche, die bei Hall-Sensoren unterhalb von 100 µm x 100 µm, und bei magnetoresistiven xMR-Sensoren (z.B. AMR, GMR, TMR, etc.) sogar im Bereich von 10 µm x 10 µm liegt, und somit ein bis zwei Größenordnungen kleiner ist. Da modernste Geräte, wie z. B. Drohnen oder Roboter, aus immer kompakteren Mechanismen und Komponenten bestehen, kann ein Bauelement gemäß Figur 1C nicht nur zu Platzproblemen, sondern auch zu Funktionsbeeinträchtigungen führen, z.B. durch Übersprechen des Magnetfelds des Back-Bias Magneten 40 auf benachbarte elektronische Komponenten. Um derartige Bauelemente in zunehmend miniaturisierten Systemen für die Detektion von Bewegungen, Geschwindigkeiten oder Positionen optimal und ressourcenschonend nutzen zu können, sollte der Back-Bias Magnet 40 substanziell verkleinert werden.

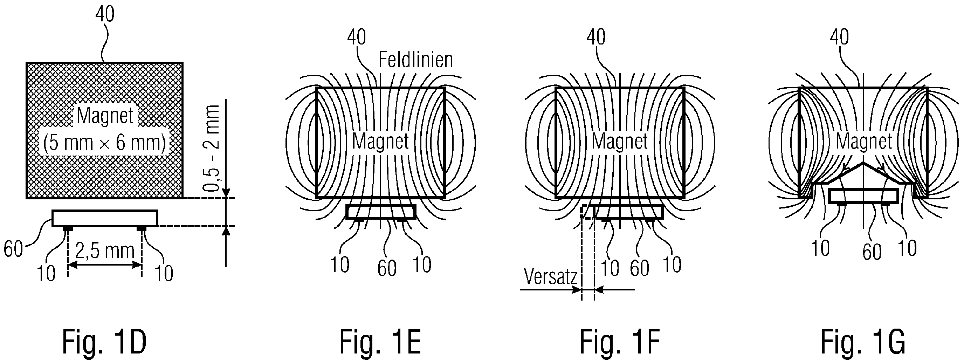

Die Miniaturisierung der Back-Bias Magnete 40 zieht jedoch einen weiteren Nachteil nach sich. Je kleiner die Back-Bias Magnete 40 ausgeführt werden, umso schwächer wird natürlich auch das Magnetfeld. Hinzu kommt, dass die kleineren Back-Bias Magnete 40 natürlich auch nur über eine entsprechend kleine Fläche einen homogenen Feldverlauf bereitstellen können. Dies soll nachfolgend unter Bezugnahme auf die Figuren 1D bis 1G kurz erläutert werden.

Wie in Figur 1D dargestellt ist, befindet sich der Back-Bias Magnet 40 üblicherweise auf der Rückseite eines Halbleiterchips 60 mit den Sensorelementen 10 auf dessen Vorderseite. Der Abstand zwischen dem Back-Bias Magneten 40 und den Sensorelementen 10 wird so gewählt, dass die Magnetfeldstärke im Bereich der Sensorelemente 10 nicht zu deren Übersteuerung führt und gleichzeitig die Modulation des Magnetfeldes durch das sich drehende Zahnrad noch gut messbar ist. Die in Figur 1D rein beispielhaft angegebenen Abmessungen beziehen sich auf ein Zahnrad mit 3 mm breiten Zähnen und einem Abstand von 1 mm bis 4 mm zwischen dem Zahnrad und dem Sensorchip 60. Die Remanenz des Back-Bias Magneten 40 liegt dabei typischerweise bei ca. 1 Tesla.

Figur 1E illustriert den Verlauf der Magnetfeldlinien in einer Anordnung gemäß Figur 1D. Da x- und y-Komponenten des Magnetfeldes in der Ebene der Sensorelemente 10 positionsbedingt erheblich variieren, ist eine präzise Justage des Back-Bias Magneten 40 gegenüber dem Sensorchip 60 symmetrisch zur Y-Achse erforderlich. Bei konventionellen Montageverfahren kann der Versatz jedoch leicht im Bereich von 0,5 mm bis 1 mm liegen.

Wie in Figur 1F dargestellt ist, sind die zwei Sensorelemente 10 des Chips 60 dann sehr unterschiedlichen Magnetfeldern ausgesetzt, was einen erheblichen Offset verursachen, und im Falle magnetoresistiver Sensorelemente (AMR, GMR usw.) sogar zu einer Übersteuerung der gesamten Sensoranordnung führen kann.

Wie in Figur 1G beispielhaft gezeigt ist, lässt sich der Verlauf der Feldlinien im Bereich des Sensorchips 60 durch eine spezielle geometrische Formgestaltung des Magneten 40 optimieren (z.B. vertikal ausrichten), wodurch sich die Montagetoleranzen erhöhen lassen. Die Herstellung solcher speziell geformter Magnete verursacht jedoch zusätzliche Kosten. Ungeachtet dessen bleibt letztlich auch die Montage bzw. Justage unverhältnismäßig aufwendig, da der Magnet 40 nichtsdestotrotz vergleichsweise exakt gegenüber den Sensorelementen 10 ausgerichtet werden muss.

Die vorliegende Erfindung schafft eine Lösung für all die oben genannten Probleme. Insbesondere können mit dem hierin beschriebenen erfindungsgemäßen Verfahren Mikromagnete hergestellt werden, die extrem nahe an den Sensorelementen platziert werden können. Somit wird gewährleistet, dass trotz der miniaturisierten Abmessungen der erfindungsgemäßen Mikromagnete ein ausreichend starkes Magnetfeld die Sensorelemente durchsetzt. Das erfindungsgemäße Verfahren erlaubt außerdem eine hochpräzise Ausrichtung der Mikromagnete gegenüber den Sensorelementen.

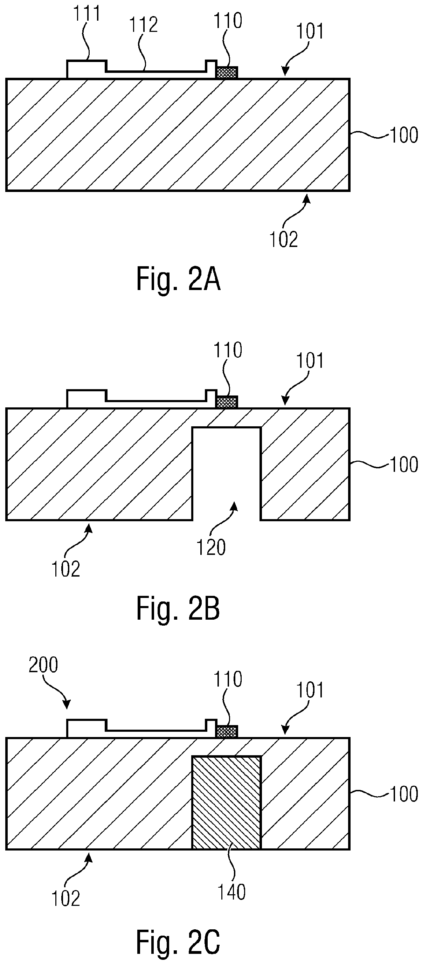

Die Figuren 2A bis 2C zeigen ein erstes Ausführungsbeispiel des erfindungsgemäßen Verfahrens zum Herstellen eines Magnetfeldsensorchips mit einem integrierten Back-Bias Magneten, wobei die einzelnen Schritte des Verfahrens anhand von strukturellen Bauteilen beschrieben werden.

Figur 2A zeigt zunächst ein Substrat 100. Hierbei kann es sich beispielsweise um ein Siliziumsubstrat handeln. Ebenfalls denkbar wären z.B. Substrate aus Glas, Keramik oder Kunststoff. Das Substrat 100 weist eine erste Substratoberfläche 101 und eine gegenüberliegende zweite Substratoberfläche 102 auf.

Auf der ersten Substratoberfläche 102 wird mindestens ein Magnetfeldsensor 110 angeordnet. Hierbei kann es sich beispielsweise um einen Hallsensor oder um einen magnetoresistiven Sensor handeln, wobei diese Art von Sensoren auch als xMR-Sensoren bezeichnet werden. Optional können auf der ersten Substratoberfläche 101 Anschlusspads 111 realisiert werden, um mittels entsprechender Verbindungsleitungen 112 den Magnetfeldsensor 110 zu kontaktieren.

Die hier schematisch angedeuteten Anschlusspads 111 können eine Schaltung symbolisieren, die Magnetfeldsensoren 110 enthält und mittels bekannter Halbleitertechnologien hergestellt wird. Sie enthält zumeist nicht nur die Anschlusspads 111 sondern auch aktive, analoge und digitale Schaltungskomponenten zur Signalkonditionierung und -auswertung.

Wie in Figur 2B zu sehen ist, wird mindestens eine Kavität 120 in der zweiten Substratoberfläche 102 erzeugt. Diese Kavität 120 kann beispielsweise unter Anwendung von Mikrostrukturierungstechniken in die zweite Substratoberfläche 102 strukturiert werden. Die Kavität 120 kann beispielsweise mittels reaktivem lonentiefenätzen (RIE bzw. DRIE: (Deep) Reactive Ion Etching) erzeugt werden.

Vorweggreifend auf Figur 2C wird in dieser Kavität 120 später ein Back-Bias Magnet 140 erzeugt. Von daher ist es sinnvoll, die Kavität 120 im Bereich des Magnetfeldsensors 110 zu erzeugen. In dem hier abgebildeten Ausführungsbeispiel wird die Kavität 120 genau gegenüberliegend von dem Magnetfeldsensor 110 erzeugt. Der Magnetfeldsensor 110 weist einen aktiven Sensorbereich auf. Vorteilhafter Weise kann die Kavität 120 daher insbesondere gegenüber von einem solchen aktiven Sensorbereich erzeugt werden. Es sind aber auch andere Anordnungen möglich, was später noch näher erläutert wird.

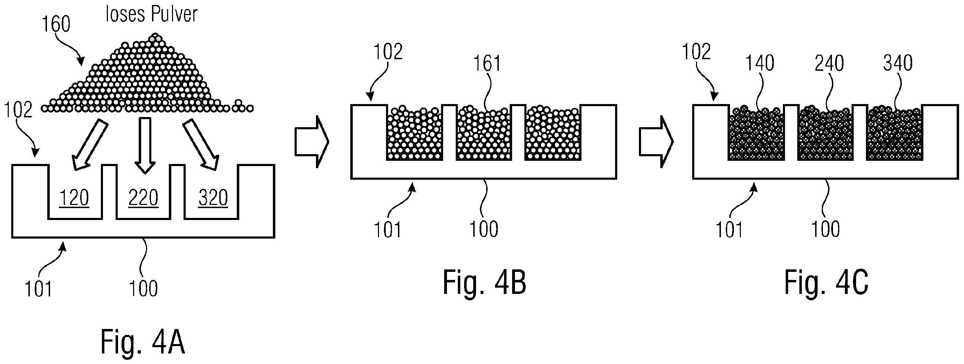

Wie in Figur 2C zu sehen ist, wird innerhalb der Kavität 120 ein Back-Bias Magnet 140 erzeugt. Der Back-Bias Magnet 140 füllt die Kavität 120 vorzugsweise vollständig aus und befindet sich dementsprechend an genau derselben Stelle, an der sich zuvor die Kavität 120 befand. Die Erzeugung des Back-Bias Magneten 140 unter Anwendung des erfindungsgemäßen Verfahrens wird später unter Bezugnahme auf die Figuren 4A bis 4C näher erläutert.

Da der Back-Bias Magnet 140 in der im Substrat 100 strukturierten Kavität 120 erzeugt wird, handelt es sich um einen integrierten Back-Bias Magneten 140, d.h. der Back-Bias Magnet 140 ist in dem gleichen Substrat 100 integriert, auf dem auch der Magnetfeldsensor 110 angeordnet ist. Im Ergebnis entsteht der in Figur 2C schematisch abgebildete Magnetfeldsensorchip 200 mit integriertem Back-Bias Magneten 140. Dies unterscheidet sich von den bisher bekannten hybriden Aufbauten, in denen der Back-Bias Magnet und der Sensor jeweils als separate Bauteile ausgeführt sind.

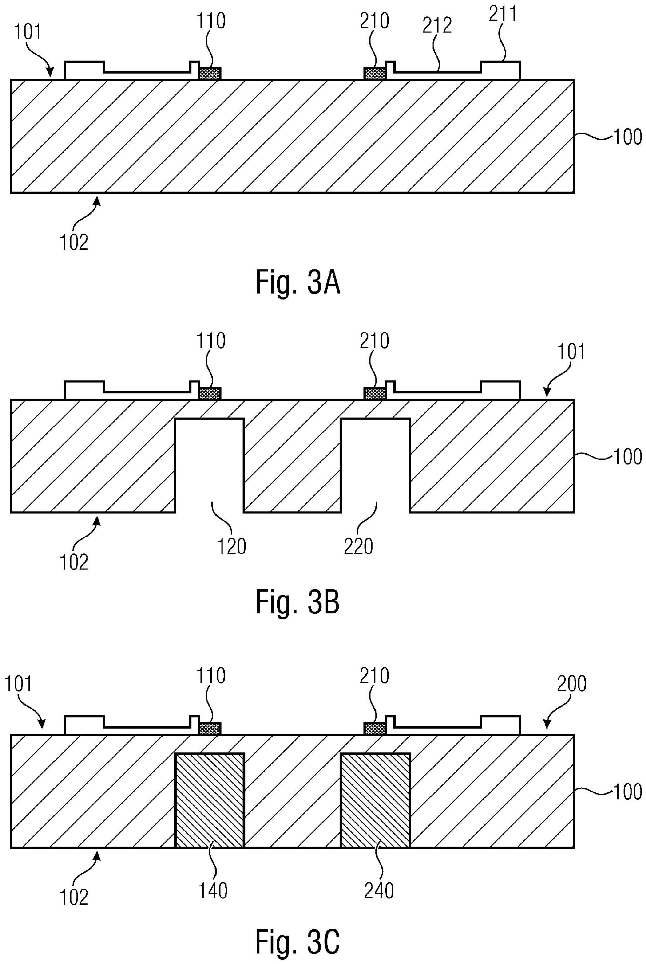

Zunächst sei auf die Figuren 3A bis 3C verwiesen, die ein weiteres denkbares Ausführungsbeispiel eines Magnetfeldsensorchips 190 zeigen, der mit dem hierin beschriebenen erfindungsgemäßen Verfahren hergestellt werden kann. Gleiche Bauteile mit gleicher oder ähnlicher Funktion, wie zuvor unter Bezugnahme auf die Figuren 2A bis 2C beschrieben, sind mit den gleichen Bezugszeichen versehen. Daher werden nachfolgend nur die Unterschiede zu den Figuren 2A bis 2C erläutert.

In Figur 3A wird auf der ersten Substratoberfläche 101 ein zusätzlicher zweiter Magnetfeldsensor 211 angeordnet. Dieser ist an dieser Stelle rein repräsentativ für eine mögliche Vielzahl an Magnetfeldsensoren 110, 210, ..., die vorhanden sein können. Optional können auch hier auf der ersten Substratoberfläche 101 entsprechende Anschlusspads 211 realisiert werden, um mittels entsprechender Verbindungsleitungen 212 den zweiten Magnetfeldsensor 210 zu kontaktieren.

Wie in Figur 3B zu sehen ist, wird eine zweite Kavität 220 in der zweiten Substratoberfläche 102 erzeugt. Diese zweite Kavität 220 kann beispielsweise unter Anwendung von Mikrostrukturierungstechniken in die zweite Substratoberfläche 102 strukturiert werden. Die zweite Kavität 120 kann beispielsweise mittels reaktivem lonentiefenätzen (RIE bzw. DRIE: (Deep) Reactive Ion Etching) erzeugt werden.

In dieser zweiten Kavität 220 wird später ein zweiter Back-Bias Magnet 240 erzeugt. Von daher ist es sinnvoll, die zweite Kavität 220 im Bereich des zweiten Magnetfeldsensors 210 zu erzeugen. In dem hier abgebildeten Ausführungsbeispiel wird die zweite Kavität 220 genau gegenüberliegend von dem zweiten Magnetfeldsensor 210 erzeugt. Der zweite Magnetfeldsensor 210 weist einen aktiven Sensorbereich auf. Vorteilhafter Weise kann die zweite Kavität 220 daher insbesondere gegenüber von einem solchen aktiven Sensorbereich erzeugt werden.

Wie in Figur 3C zu sehen ist, wird innerhalb der zweiten Kavität 220 ein zweiter Back-Bias Magnet 240 erzeugt. Der zweite Back-Bias Magnet 240 füllt die zweite Kavität 220 vorzugsweise vollständig aus und befindet sich dementsprechend an genau derselben Stelle, an der sich zuvor die zweite Kavität 220 befand.

Da die Back-Bias Magnete 140, 240 in den im Substrat 100 strukturierten Kavitäten 120, 220 erzeugt werden, handelt es sich um integrierte Back-Bias Magnete 140, 240, d.h. die Back-Bias Magnete 140, 240 sind in dem gleichen Substrat 100 integriert, auf dem auch die Magnetfeldsensoren 110, 210 angeordnet sind. Im Ergebnis entsteht der in Figur 3C schematisch abgebildete Magnetfeldsensorchip 200 mit integrierten Back-Bias Magneten 140, 240. Dies unterscheidet sich von den bisher bekannten hybriden Aufbauten, in denen der Back-Bias Magnet und der Sensor jeweils als separate Bauteile ausgeführt sind.

Sofern mehrere (d.h. mindestens zwei) Magnetfeldsensoren 110, 210 vorgesehen sind, so kann jedem dieser Magnetfeldsensoren 110, 210 mindestens ein Back-Bias Magnet 140, 240 zugeordnet sein. Andere Ausführungsbeispiele, in denen einem Magnetfeldsensor 110 mehr als ein Back-Bias Magnet 140 zugeordnet ist, sind ebenfalls denkbar und werden später beschrieben.

Die Figuren 4A bis 4C zeigen zunächst rein schematisch, wie Back-Bias Magnete 140, 240, 340 unter Anwendung des erfindungsgemäßen Verfahrens innerhalb der jeweiligen Kavität 120, 220, 320 erzeugt werden können. In den Figuren 4A bis 4C ist ein zuvor beschriebenes Substrat 100 zu sehen. Im Vergleich zu den Figuren 2A bis 3C ist das Substrat 100 jedoch um 180° gedreht. In der zweiten Substratoberfläche 102 sind mehrere, hier rein beispielhaft drei, Kavitäten 120, 220, 320 strukturiert worden. Der Übersichtlichkeit wegen sind hier die zuvor beschriebenen Magnetfeldsensoren 110 auf der ersten Substratoberfläche 101 nicht dargestellt.

Zunächst wird ein loses Pulver 160 aus magnetischem Material in die Kavitäten 120, 220, 320 eingefüllt. Das Pulver 160 weist zu einem Anteil von über 50% Partikel 161 aus magnetischem Material auf. Hierbei kann es sich um hartmagnetisches oder weichmagnetisches Material handeln. Die einzelnen Partikel 161 können eine Partikelgröße im Mikrometerbereich aufweisen.

Nach dem Verfüllen der Kavitäten 120, 220, 320 mit dem losen Pulver 160 werden die Partikel 161 mittels einer speziell angepassten Atomlagenabscheidung (ALD) zu einer mechanisch festen Magnetkörperstruktur agglomeriert. Das heißt, die zuvor losen Partikel 161 sind nun zu einer mechanisch festen Struktur zusammengefügt und bilden die zuvor beschriebenen Back-Bias Magnete 140, 240, 340. Es bildet sich in jeder befüllten Kavität 120, 220, 340 jeweils genau ein Back-Bias Magnet 140, 240, 340.

Die Figuren 4A bis 4C dienen rein der schematischen Beschreibung der Erzeugung der Back-Bias Magnete 140, 240, 340 in den Kavitäten 110, 210, 310. Der Vereinfachung wegen sind die zuvor erwähnten Magnetfeldsensoren 110, 210 hier nicht abgebildet. Es ist jedoch vorgesehen, dass auf der ersten Substratoberfläche 101 mindestens ein Magnetfeldsensor 110 angeordnet ist. Es wäre beispielsweise denkbar, dass pro Back-Bias Magnet 140, 240, 340 jeweils ein zugehöriger Magnetfeldsensor 110, 210, ... vorgesehen ist. Ein Vorteil der Nutzung des oben beschriebenen Verfahrens zur Erzeugung der Back-Bias Magnete 140, 240, 340 liegt darin, dass die integrierten 3D-Mikrostrukturen, d.h. die integrierten Back-Bias Magnete 140, 240, 340, aus beliebigen magnetischen Pulvermaterialien hergestellt werden können, einschließlich der Verwendung von Gemischen unterschiedlicher Materialien. Es kann auch ein Gemisch aus Partikeln 161 unterschiedlicher Größe ein und desselben Materials verwendet werden, um die Fülldichte der Mikromagnete 140, 240, 340 zu maximieren und somit deren Remanenz zu steigern. Während für ein unidisperses kugelförmiges Pulver 160 eine Fülldichte von maximal 64% erreicht werden kann, ist für ein Gemisch aus kleinen und großen Partikeln 161 mit einem Größenverhältnis von 1:10 eine Fülldichte von bis zu 87% möglich [8].

Des erfindungsgemäße Verfahren bietet eine unkomplizierte und kostenoptimierte Möglichkeit zur Herstellung von magnetischen 3D-Mikrostrukturen, d.h. von integrierten Back-Bias Magneten 140, auf planaren Substraten 100 aus, z.B. Silizium, Glas, Keramik oder Kunststoff, sowie die Möglichkeit zur Kombination dieser mikrostrukturierten Back-Bias Magnete 140, 240, 340 mit Magnetfeldsensoren 110, 210 auf ein- und demselben Substrat 100.

Im einfachsten Fall kann ein Siliziumsubstrat 100 mit fertig prozessierten, magnetoresistive Sensoren oder Hallsensoren aufweisenden Schaltungen, mit hartmagnetischen 3D-Mikrostrukturen (Mikromagneten) 140, 240, 340 versehen werden, indem das oben beschriebene Agglomerationsverfahren auf der Rückseite 102 des Substrats 100 ausgeführt wird.

Erfindungsgemäß wird hierbei der Schritt des Erzeugens des mindestens einen Back-Bias Magneten 140 zeitlich nach dem Schritt des Anordnens des Magnetfeldsensors 110 ausgeführt. Das heißt, die Mikromagnete 140, 240, 340 können nach erfolgter vollständiger Realisierung der Magnetfeldsensoren 110, 210 erzeugt werden, so dass der Herstellungsprozess der Magnetfeldsensoren 110, 210 nicht eingeschränkt wird. Dies ist ein Vorteil der vorliegenden Erfindung, denn das hierin beschriebene Verfahren ist kompatibel zur sogenannten Back-End-Of-Line (BEOL), dem zweiten, auf die Fertigung der Transistoren folgenden Teil eines Halbleiterprozesses, der vor allem die Realisierung von Mehrlagen-Umverdrahtungen aus Metallen wie Al und Cu sowie das Vereinzeln des Halbleitersubstrats in Chips umfasst. Zur Erzeugung der Back-Bias Magnete 140, 240, 340 unter Anwendung des oben erwähnten Agglomerationsverfahrens mittels ALD sind nämlich keine hohen Prozesstemperaturen von ≥ 500°C nötig, welche die integrierten Schaltungen und/oder Magnetfeldsensoren 110, 210 zerstören würden. Es können also zuerst die Magnetfeldsensoren 110 einschließlich integrierter Schaltungen vollständig hergestellt werden, einschließlich der Mehrlagen-Umverdrahtungen, und im Anschluss daran, vor dem Vereinzeln in Chips, können dann die mikrostrukturierten Back-Bias Magnete 140 erzeugt werden.

Neben der soeben erwähnten BEOL-Kompatibilität weist das erfindungsgemäße Verfahren noch einen weiteren Vorteil auf. Die Kavitäten 120, 220 können nämlich hochpräzise erstellt werden, d.h. die Kavitäten 120, 220 können exakt so ausgerichtet werden, dass die Feldlinien der in den Kavitäten 120, 220 erzeugten Back-Bias Magnete 140, 240 möglichst homogen durchsetzen. Anders ausgedrückt, können die Kavitäten 120, 220 (und somit auch die darin erzeugten Back-Bias Magnete) sehr genau an einer gewünschten Position relativ zum Magnetfeldsensor 110 platziert werden. Dies ist deutlich unkomplizierter im Vergleich zu hybriden Bauformen, bei denen die Back-Bias Magnete gegenüber den Sensoren ausgerichtet und montiert werden müssen.

Aufgrund dieser exakten Positionierung des integrierten Back-Bias Magneten 140, ist es möglich, am Magnetfeldsensor 110 ein Magnetfeld mit gewünschter Magnetfeldcharakteristik zu erzeugen. Wenn der integrierte Back-Bias Magnet 140 beispielsweise einem aktiven Sensorbereich des Magnetfeldsensors 110 gegenüberliegend angeordnet ist, dann wirkt das vom Back-Bias Magneten 140 erzeugte Magnetfeld nur senkrecht zur Chipoberfläche, d.h. senkrecht zur ersten bzw. zweiten Substratoberfläche 101, 102. Hier spricht man auch von einem in z-Richtung gerichteten Magnetfeld.

Der Magnetfeldsensor 110 kann beispielsweise in Form eines sogenannten 3D-Hallsensors ausgestaltet sein. Dieser ist ausgestaltet, um Magnetfeldvektoren in allen drei Raumrichtungen zu detektieren. Hierfür kann der 3D-Hallsensor 110 beispielsweise drei Hall-Elemente aufweisen, wobei jedes Hall-Element für jeweils eine Raumrichtung empfindlich ist, d.h. es können ein X-Hall-Element, ein Y-Hall-Element und ein Z-Hall-Element vorgesehen sein.

Sofern also, wie eingangs erwähnt, am Ort des aktiven Sensorbereichs ein Magnetfeld wirkt, welches senkrecht zur Chipoberfläche wirkt (d.h. in Z-Richtung), dann misst beispielsweise das Z-Hall-Element das volle Feld, während das X-Hall-Element und das Y-Hall-Element hingegen kein Feld messen.

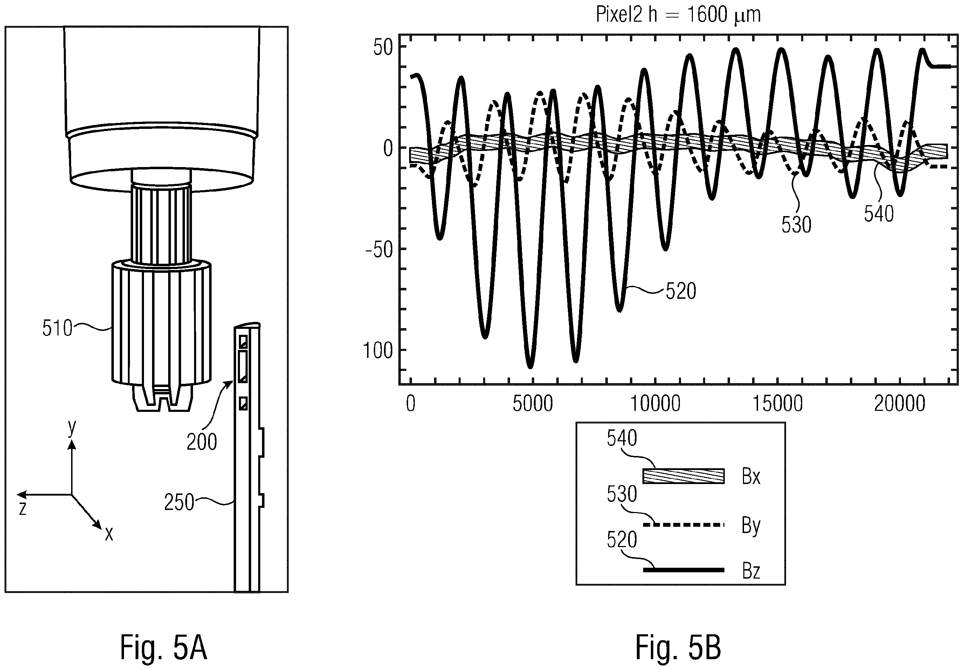

In den Figuren 5A und 5B ist ein entsprechendes Beispiel eines erfindungsgemäßen Magnetfeldsensorchips 200 gezeigt, der auf einer Platine 250 angeordnet ist. Der Magnetfeldsensorchip 200 weist einen (hier nicht explizit sichtbaren) Magnetfeldsensor und einen, dem Magnetfeldsensor gegenüberliegend angeordneten, integrierten Back-Bias Magneten auf. Dreht sich ein (magnetischer) Geber 510 vor dem Magnetfeldsensorchip 200, so ist dies sehr deutlich anhand der Z-Komponente 520 (Fig. 5B) ersichtlich, d.h. das Z-Hall-Element registriert einen großen Ausschlag. Bei dem (magnetischen) Geber 510 kann es sich beispielsweise, wie hier in Figur 5A dargestellt, um ein magnetisiertes Zahnrad handeln, das ansonsten nichtmagnetisch ist. Es kann sich aber auch um ein dauerhaft magnetisiertes Bauteil, wie zum Beispiel einen Permanentmagneten, handeln.

Aufgrund der oben erwähnten Anordnung des integrierten Back-Bias Magneten 140 ist der Magnetfeldkomponente in Z-Richtung allerdings auch ein sehr starkes statisches Magnetfeld überlagert, nämlich das Grundmagnetfeld des Back-Bias Magneten 140. (Anm.: Das Grundfeld ist in Figur 5B nicht zu sehen, da der Offset angehoben wurde). Der Magnetfeldsensor 110 wiese somit in Z-Richtung ein eher ungünstiges Signal-Rausch Verhältnis (SNR) auf.

Das Y-Hall-Element hingegen sähe in diesem Beispiel zunächst kein Magnetfeld in Empfindlichkeitsrichtung, sofern der Geber 510 (z.B. Zahnrad) nicht vorhanden ist. Erst durch Anwesenheit des Gebers 510 wird das Magnetfeld abgelenkt, und eine Feldkomponente in Empfindlichkeitsrichtung (hier: in Y-Richtung) ist messbar. Das entsprechende Signal 530 des Y-Hall-Elements kann hierbei deutlich rauschärmer ausgegeben werden als das Signal 520 des Z-Hall-Elements, da das Grundfeld des Back-Bias Magneten 140 nur in Z-Richtung wirkt und dementsprechend keine Y-Komponente aufweist. Anders ausgedrückt, überlagert sich das Grundfeld des Back-Bias Magneten 140 hier nicht der zu messenden Y-Komponente 530. In Figur 5B weist die Y-Komponente 530 zwar eine geringere Amplitude auf als die Z-Komponente 520. Ohne das sich überlagernde Grundfeld kann das Sensorsignal 530 des Y-Hall-Elements aber deutlich verstärkt werden.

Zusätzlich kann die X-Komponente 540 als eine Art Spurführung verwendet werden. Ist der Geber 510 (z.B. Zahnrad) mittig platziert, so sieht das X-Hall-Element kein Feld. Ist der Geber 510 nicht mittig platziert, so entsteht eine X-Komponente 540, die das X-Hall-Element messen kann. Die oben genannten Vorteile sind mit dem erfindungsgemäßen integrierten Back-Bias Magneten 140 realisierbar, da hier die Montagetoleranzen genau genug sind. Mit einem hybriden Aufbau ist dies nahezu nicht realisierbar.

Wie eingangs bereits kurz erwähnt wurde, lassen sich die Kavitäten 120, 220, in denen die Back-Bias Magnete 140, 240 erzeugt werden, unter Anwendung von Mikrostrukturierungsverfahren erzeugen. Hierfür kann beispielsweise das sogenannte Deep Reactive Ion Etching (DRIE, auch Bosch-Prozeß genannt) genutzt werden. Die in einem Silizium-Substrat erzeugten Kavitäten 120, und dementsprechend die darin erzeugten Mikromagnete 140, können lateral beliebige Geometrien aufweisen. Einem Sensorelement 110 können auch mehrere Magnete 140 zugeordnet werden, da das oben beschriebene Verfahren die Herstellung von Back-Bias Magneten 140 mit einer Strukturbreite zwischen 25 µm und 2000 µm erlaubt [7].

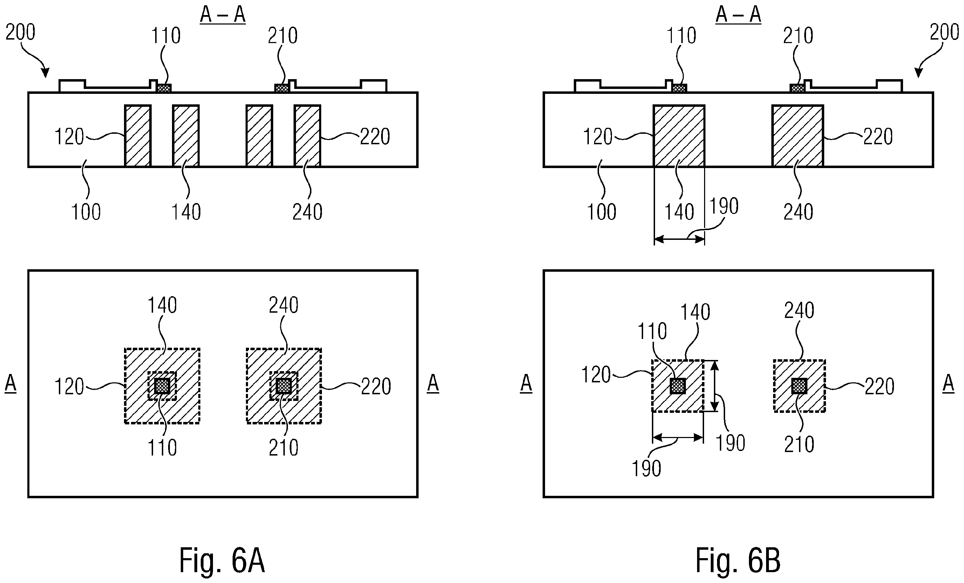

Das heißt, eine Kavität 120 kann derart erzeugt werden, dass sie eine laterale Ausdehnung zwischen 25 µm und 2000 µm aufweist, sodass der darin erzeugte Back-Bias Magnet 140 als ein Mikromagnet ausgestaltet ist, der eine Strukturbreite zwischen 25 µm und 2000 µm aufweist. Entsprechende Ausführungsbeispiele werden nachfolgend unter Bezugnahme auf die Figuren 6A und 6B näher erläutert. Darin ist jeweils ein Substrat 100 mit einer fertig prozessierten Schaltung gezeigt, wobei die Schaltung Magnetfeldsensoren 110, 210 in Form von magnetoresistiven Sensoren oder Hall-Sensoren aufweist sowie Anschluss-Pads 111, 211. Auf der Rückseite 102 des Substrats 100 sind Mikromagnete 140, 240 mit unterschiedlichen Geometrien eingebettet.

Figur 6A zeigt in der oberen Darstellung einen schematischen Querschnitt durch einen erfindungsgemäßen Magnetfeldsensorchip 200 mit zwei ringförmigen Back-Bias Magneten 140, 240. In der unteren Darstellung ist eine entsprechende Draufsicht auf den Magnetfeldsensorchip 200 gezeigt. Nachfolgend werden die entsprechenden Verfahrensschritte zum Herstellen des Magnetfeldsensorchips 200 am Beispiel der ersten Kavität 120 und des darin erzeugten ersten Back-Bias Magneten 140, sowie am Beispiel des ersten Magnetfeldsensors 110 beschrieben. Diese Beschreibung gilt aber ebenso für die hier gezeigte zweite Kavität 220 und den darin erzeugten zweiten Back-Bias Magneten 240, sowie für den zweiten Magnetfeldsensor 210. Diese Beschreibung gilt ebenso für hier nicht gezeigte weitere Kavitäten sowie für weitere Back-Bias Magnete und weitere Magnetfeldsensoren.

Gemäß Figur 6A beinhaltet der Schritt des Strukturierens der ersten Kavität 120, dass die erste Kavität 120 in Form einer Grabenstruktur in das Substrat 100 strukturiert wird. In der Draufsicht (Fig. 6A, unten) ist zu sehen, dass sich diese Grabenstruktur um einen aktiven Sensorbereich des Magnetfeldsensors 110 herum erstreckt, sodass sich letztlich auch der in der ersten Kavität 120 erzeugte Back-Bias Magnet 140 um den aktiven Sensorbereich des Magnetfeldsensors 110 herum erstreckt.

Wie in der Draufsicht zu erkennen ist, ist die Grabenstruktur 120 ringförmig ausgestaltet, d.h. die erste Kavität 120 wird in Form einer, in sich geschlossenen, ringförmigen Grabenstruktur erzeugt, die sich vollumfänglich um den aktiven Sensorbereich des Magnetfeldsensors 110 herum erstreckt. In anderen Worten ist der aktive Sensorbereich des Magnetfeldsensors 110, in der Draufsicht gesehen, innerhalb der ringförmigen Grabenstruktur 120 angeordnet.

Alternativ wäre es denkbar, dass die erste Kavität 120 in Form einer ringförmigen Grabenstruktur mit Unterbrechungen ausgestaltet ist. Das heißt, die erste Kavität 120 kann mehrere unterbrochene Grabenstruktur-Segmente aufweisen. Diese können wiederum, wie in Figur 6A abgebildet, um den aktiven Sensorbereich des Magnetfeldsensors 110 herum angeordnet sein.

Durch die unter Bezugnahme auf Figur 6A diskutierten ringförmigen Ausführungsbeispiele ist es möglich, am Ort des aktiven Sensorbereichs ein Magnetfeld ohne Z-Komponente zu erzeugen. Das heißt, in diesen Ausführungsbeispielen misst der Magnetfeldsensor 110 keine Z-Komponente des statischen Magnetfelds des Back-Bias Magneten 140. Dadurch kann das Signal-Rausch-Verhältnis (SNR) deutlich erhöht werden.

Figur 6B zeigt ein weiteres Ausführungsbeispiel eines erfindungsgemäßen Magnetfeldsensorchips 200, wobei in der oberen Darstellung erneut ein schematischer Querschnitt gezeigt ist, und in der unteren Darstellung ist eine entsprechende Draufsicht auf den Magnetfeldsensorchip 200 gezeigt.

Diese Ausgestaltung entspricht im Wesentlichen dem zuvor unter Bezugnahme auf Figur 3C diskutierten Ausführungsbeispiel, weshalb an dieser Stelle auf erneute Beschreibung der jeweiligen Elemente verzichtet wird.

In Figur 6B ist jedoch die zuvor erwähnte Strukturbreite bzw. laterale Ausdehnung eingezeichnet, die mit dem Bezugszeichen 190 gekennzeichnet ist. Hierbei handelt es sich um die laterale Ausdehnung der Kavität 120 in der Substratebene. Die laterale Ausdehnung kann sowohl die Ausdehnung in eine erste laterale Richtung (z.B. entlang der Länge des Substrats 100), als auch die Ausdehnung in eine zweite laterale Richtung (z.B. entlang der Breite des Substrats 100) betreffen. Das gleiche gilt natürlich auch für den in der Kavität 120 erzeugten Back-Bias Magneten 140. Dieser kann im Wesentlichen die gleiche Strukturbreite bzw. laterale Ausdehnung wie die Kavität 120 aufweisen.

Das heißt, die erste Kavität 120 kann derart erzeugt werden, dass sie eine laterale Ausdehnung 190 zwischen 25 µm und 2000 µm aufweist, sodass der darin erzeugte Back-Bias Magnet 140 als ein Mikromagnet ausgestaltet ist, der eine Strukturbreite 190 zwischen 25 µm und 2000 µm aufweist.

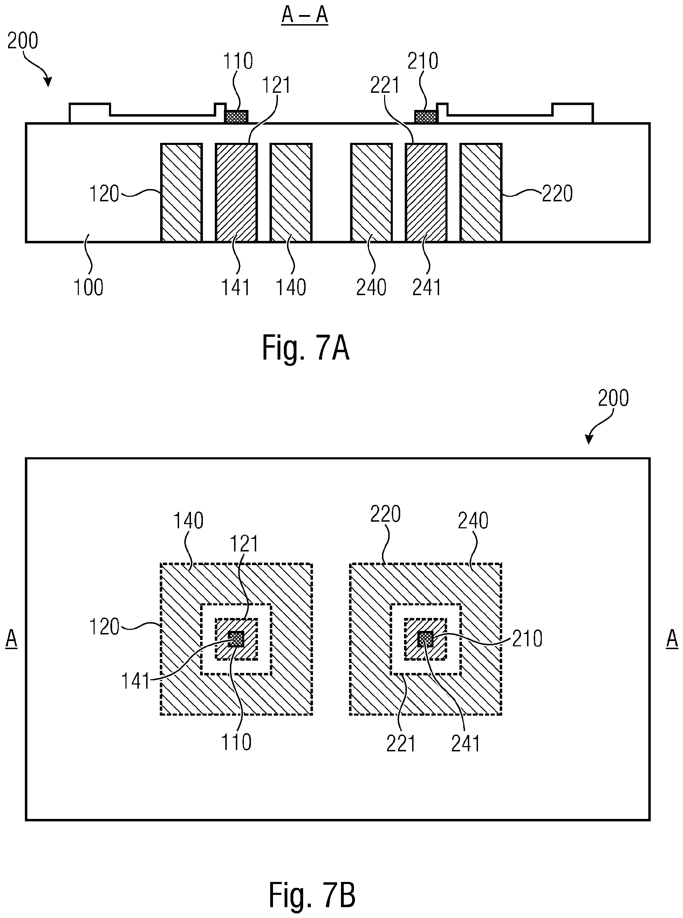

Des Weiteren ist es möglich, hartmagnetische und weichmagnetische 3D-Mikrostrukturen miteinander zu kombinieren, um das Magnetfeld im aktiven Sensorbereich optimal zu formen. Die Figuren 7A und 7B zeigen ein entsprechendes Ausführungsbeispiel, bei dem eine hartmagnetische 3D-Mikrostruktur, d.h. ein mikrostrukturierter Back-Bias Magnet 140, eine dem Sensor 110 gegenüberliegend angeordnete weichmagnetische 3D-Mikrokörperstruktur 141 umringt. In diesem Fall kann die weichmagnetische 3D-Mikrokörperstruktur 141 beispielsweise wie ein Kern im Inneren des ringförmigen Back-Bias Magneten 140 wirken. Die weichmagnetische 3D-Mikrokörperstruktur 141 kann daher auch als Mikrokern bezeichnet werden.

Zur Herstellung des hier gezeigten Magnetfeldsensorchips 200 kann z.B. nach dem Erzeugen des mikrostrukturierten Back-Bias Magneten 140, z.B. aus NdFeB-Pulver gemäß den Figuren 4A bis 4C, dieselbe Prozedur noch einmal durchgeführt werden, allerdings mit einem weichmagnetischen Pulvermaterial, wie z.B. Fe oder NiFe. Dies soll nachfolgend unter Bezugnahme auf die Figuren 7A und 7B näher erörtert werden.

Figur 7A zeigt einen schematischen Querschnitt durch einen erfindungsgemäßen Magnetfeldsensorchip 200 mit zwei ringförmigen Back-Bias Magneten 140, 240, die jeweils eine zusätzliche 3D-Mikrokörperstruktur 141, 241 umringen. Figur 7B zeigt eine entsprechende Draufsicht auf den Magnetfeldsensorchip 200. Die nachfolgende Beschreibung bezieht sich auf den ersten Magnetfeldsensor 110, auf die erste Kavität 120, auf die erste zusätzliche Kavität 121, sowie auf den ersten ringförmigen Back-Bias Magneten 140 und die erste zusätzliche 3D-Mikrokörperstruktur 141. Alles gilt aber natürlich auch für die hier abgebildeten zweiten und weitere entsprechende Elemente 210, 220, 221, 240, 241.

In diesem Ausführungsbeispiel wird zusätzlich zu der ersten Kavität 120 eine zusätzliche Kavität 121 in die zweite Substratoberfläche 102 strukturiert. Ähnlich wie in Figur 6A ist die erste Kavität 120 hier in Form einer (in sich geschlossenen oder unterbrochenen) ringförmigen Grabenstruktur ausgestaltet, die sich um den aktiven Sensorbereich des Magnetfeldsensors 110 herum erstreckt, d.h. in einer Draufsicht (Fig. 7B) ist der aktive Sensorbereich innerhalb der ringförmigen ersten Kavität 120 angeordnet.

Die soeben erwähnte zusätzliche Kavität 121 wird, in einer Draufsicht auf eine der beiden Substratoberflächen 101, 102 (siehe Fig. 7B), innerhalb der ringförmigen ersten Kavität 120 erzeugt. Die zusätzliche Kavität 121 wird also von der ringförmigen ersten Kavität 120 umringt. Die zusätzliche Kavität 121 kann beispielsweise gegenüberliegend von dem Magnetfeldsensor 110 strukturiert werden, sodass diese zusätzliche Kavität 240 dem aktiven Sensorbereich des Magnetfeldsensors 110 gegenüberliegt.

In einem nächsten Schritt kann in der zusätzlichen Kavität 121 eine 3D-Mikrokörperstruktur erzeugt werden. Hierfür kann wieder das oben beschriebene Verfahren zur Anwendung kommen, d.h. die zusätzliche Kavität 121 kann mit einem losen Pulver 160 aus einem magnetischen Material befüllt werden, welches anschließend mittels ALD agglomeriert wird. Im Gegensatz zur Erzeugung des hartmagnetischen Back-Bias Magneten 140 kann es sich hierbei jedoch um ein weichmagnetisches Material handeln, d.h. die zusätzliche Kavität 121 kann mit einem ein weichmagnetisches Material aufweisenden losen Pulver 160 befüllt, und anschließend mittels ALD verfestigt werden. Dadurch wird innerhalb der zusätzlichen Kavität 121 eine weichmagnetische 3D-Mikrokörperstruktur 141 erzeugt, die von dem hartmagnetischen Back-Bias Magneten 140 umringt wird, und die aufgrund ihrer Eigenschaften auch als Mikrokern bezeichnet werden kann.

In einer Draufsicht auf eine der beiden Substratoberflächen 101, 102 (siehe Fig. 7B), überdecken sich der aktive Sensorbereich des Magnetfeldsensors 110 und der in der zusätzlichen Kavität 121 erzeugte Mikrokern 141. Das heißt, der im Substrat 100 integrierte zusätzliche Mikrokern 141 ist dem aktiven Sensorbereich des Magnetfeldsensors 110 gegenüberliegend angeordnet. Dadurch kann das von dem ringförmigen Back-Bias Magneten 140 erzeugte Magnetfeld besonders vorteilhaft geformt werden, sodass eine möglichst homogene Feldverteilung im aktiven Sensorbereich vorliegt.

Wie alle hierin beschriebenen Kavitäten kann auch die zusätzliche Kavität 141 unter Anwendung von Mikrostrukturierungstechniken, wie z.B. DRIE-Ätzen, erzeugt werden. Bekanntlich variiert die Ätzrate eines Trockenätzprozesses über die Substratfläche, so dass im Falle von DRIE (Bosch-Prozeß) in der Mitte des Wafers tiefere Kavitäten entstehen als am Rand.

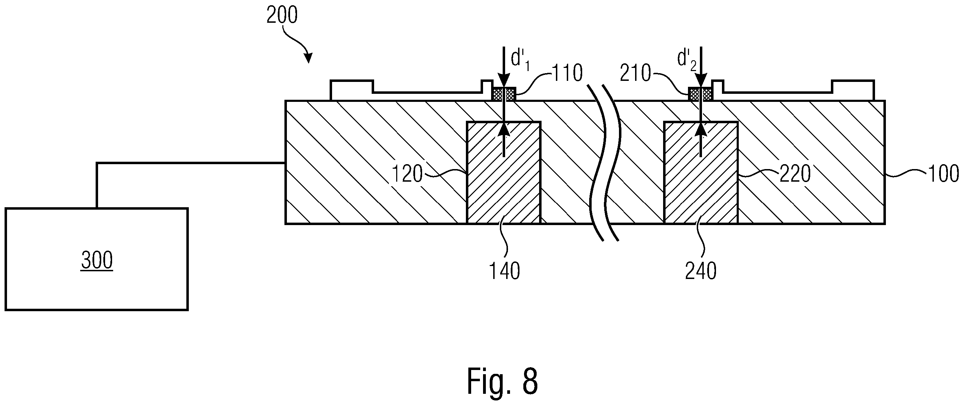

Wie Figur 8 illustriert, ist dann im Falle eines zeitgesteuerten Ätzprozesses der Abstand d'₁ zwischen dem Magnetfeldsensor 110 und der Kavität 120 in der Mitte des Wafers deutlich kleiner als der Abstand d'₂ zwischen dem Magnetfeldsensor 210 und der Kavität 220 am Rand des Wafers. Gleichzeitig ist damit natürlich auch das Volumen der in den jeweiligen Kavitäten 120, 220 erzeugten Mikromagnete 140, 240 unterschiedlich, d.h. der innere Magnet 140 (bezogen auf die Waferfläche) weist in diesem Falle ein größeres Volumen auf als der äußere Magnet 240. Dies verursacht naturgemäß eine Variation der jeweiligen Magnetfeldcharakteristiken, was zu Messabweichungen zwischen den jeweiligen Magnetfeldsensoren 110, 210 führt.

Erfindungsgemäß können solche Schwankungen bzw. Messabweichungen zwischen zwei (oder mehreren) Magnetfeldsensoren 110, 210 durch schaltungstechnische Maßnahmen korrigiert bzw. kompensiert werden. Dementsprechend sieht das erfindungsgemäße Verfahren vor, dass eine Kompensationsschaltung 300 bereitgestellt wird, die dazu ausgestaltet ist, um den Magnetfeldsensorchip 200 derart anzusteuern, dass Messabweichungen, die auf die prozessbedingten unterschiedlichen Magnetfeldcharakteristiken zurückzuführen sind, kompensiert werden können.

Gemäß weiteren Ausführungsbeispielen kann die Kompensationsschaltung 300 alternativ oder zusätzlich dazu ausgestaltet sein, um andere Messabweichungen, die durch andere Störgrößen bedingt sind, zu reduzieren bzw. kompensieren. Beispielsweise kann die Kompensationsschaltung 300 ausgestaltet sein, um den Einzelphasen-Offset des Magnetfeldsensors 110 zu kompensieren. Die Kompensationsschaltung 300 kann auch dazu verwendet werden, um Messabweichungen auszugleichen bzw. zu kompensieren, die durch die oben beschriebenen Prozesstoleranzen bedingt sind.

Da der Back-Bias Magnet 140 erfindungsgemäß in demselben Substrat 100 integriert ist wie der Magnetfeldsensor 110 ergibt sich ein weiterer messtechnischer Vorteil. Aufgrund der Integration in dasselbe Substrat 100 und dank der hohen thermischen Leitfähigkeit von Silizium weist der Back-Bias Magnet 140 die gleiche Temperatur auf wie der Magnetfeldsensor 110. Bei Magnetfeldsensoren 110 in CMOS-Technik, wie z.B. Hall-Sensoren, kann die Temperatur mit entsprechenden Schaltungen gemessen werden. Bei bekannter Magnettemperatur kann die temperaturabhängige Feldstärke des Back-Bias Magneten 140 korrigiert werden. Dies ist ebenfalls nur mit integrierten Magneten möglich. Ausführungsbeispiele der Erfindung sehen daher vor, dass die Kompensationsschaltung 300 ausgestaltet ist, um Messabweichungen zu kompensieren, die auf eine temperaturabhängige Änderung des Magnetfelds des Back-Bias Magneten 140 zurückzuführen sind.

Sind neben dem Magnetfeldsensor 110 mit dahinterliegendem Back-Bias Magneten 140 noch weitere Sensoren auf dem Magnetfeldsensorchip 200 angeordnet (ohne weitere zusätzliche Back-Bias Magnete), so können diese zusätzlichen Sensoren dazu verwendet werden, um das Geberfeld des Back-Bias Magneten 140 von Störfeldern zu unterscheiden. In einem beispielhaft realisierten Prototypen misst beispielsweise der Magnetfeldsensor 110 mit direkt gegenüberliegend angeordnetem Back-Bias Magneten 140 eine Feldstärke von ca. 75 mT. Ein zweiter, nur 2 mm entfernter Sensor ohne eigenen Back-Bias Magneten, misst hiervon nur 2 mT. Das heißt, der zweite Sensor kann somit fast unabhängig vom Nutzmagnetfeld des Back-Bias Magneten 140 externe Störfelder detektieren. Auch dies wird rein dadurch möglich, dass der miniaturisierte Back-Bias Magnet 140 erfindungsgemäß in das Substrat integriert wird, und hochpräzise so positioniert werden kann, dass deren Magnetfeld nahezu ausschließlich den zugehörigen Magnetfeldsensor 110 durchsetzt.

Entsprechende Ausführungsbeispiele der Erfindung sehen demnach vor, dass neben dem Magnetfeldsensor 110 mindestens ein zweiter Magnetfeldsensor vorgesehen ist, wobei dieser zweite Magnetfeldsensor weitestgehend außerhalb des Nutzmagnetfelds des Back-Bias Magneten 140 angeordnet wird. Hierunter ist zu verstehen, dass der zusätzliche Magnetfeldsensor in einem Bereich angeordnet wird, in dem nur noch < 10% der maximalen Feldstärke des Back-Bias Magneten 140 (in Z-Richtung, d.h. senkrecht zur Chipebene) vorhanden sind.

Die Kompensationsschaltung 300 kann dementsprechend dazu ausgestaltet sein, um das von dem zusätzlichen Magnetfeldsensor ermittelte Störfeld zu kompensieren, indem die entsprechende Störfeldgröße von dem Signal des ersten Magnetfeldsensors 110 abgezogen wird.

Für alle hierin beschriebenen Kavitäten gilt, dass die Kavitäten derart in das Substrat 100 strukturiert werden, dass sie sich von der zweiten Substratoberfläche 102 aus, in Richtung der ersten Substratoberfläche 101 erstrecken. Die Kavitäten werden dabei bis kurz vor dem Erreichen der ersten Substratoberfläche 101 in das Substrat 100 strukturiert. Das heißt, die Kavitäten werden so tief in das Substrat 100 strukturiert, dass sich die Kavitäten möglichst nah an der ersten Substratoberfläche 101, und damit möglichst nah an den auf der ersten Substratoberfläche 101 angeordneten Magnetfeldsensoren 110, 210, befinden. Dadurch kann ein möglichst geringer Abstand zwischen den Magnetfeldsensoren 110, 210 und den in den jeweiligen Kavitäten erzeugten Magneten bzw. Mikrokörperstrukturen erzielt werden.

Das hierin beschriebene erfindungsgemäße Verfahren bietet eine Möglichkeit zur Herstellung kostengünstiger, miniaturisierter Magnetfeld-Sensoren mit einem integrierten Back-Bias-Magneten zur Detektion von Bewegung, Geschwindigkeit oder Position in verschiedensten Anlagen und Geräten. Zum Zwecke der Miniaturisierung derartiger Komponenten wird vorgeschlagen, mikrostrukturierte Magnete herzustellen, die sich im Vergleich zu hybriden Bauformen näher am Sensor befinden, indem sie in den Chip integriert sind, und die ein anwendungsspezifisches "Shaping" des Magnetfeldes erlauben.

Das erfindungsgemäße Verfahren, sowie der mit diesem Verfahren herstellbare Magnetfeldsensorchip 200, weisen u.a. folgende Vorteile auf:
- Die erhebliche Reduzierung der Baugröße um bis zu einer Größenordnung erlaubt die Verwendung derartiger Bauelemente in besonders kompakten elektronischen Systemen.
- Durch die Einsparung an Material, insbesondere von Selten-Erden-Metallen, und den vereinfachten Fertigungs- bzw. Assembly-Prozess werden die Kosten reduziert.
- Es können neuartige, bisher nicht realisierbare Sensoranordnungen bzw. -systeme entwickelt werden.
- Es ergeben sich neue Möglichkeiten, Prozesstoleranzen, thermisch induzierte Drifteffekte oder magnetische Störfelder mittels geeigneter Kompensationsschaltungen zu reduzieren.

Das hierin beschriebene Verfahren schafft eine Sensoranordnung, bestehend aus einer integrierten Schaltung mit einem oder mehreren Magnetfeldsensoren und einem oder mehreren, den Magnetfeldsensoren zugeordneten magnetischen 3D-Mikrostrukturen, die sich in Kavitäten auf der Rückseite desselben Siliziumsubstrats befinden.

Die Erzeugung der Kavitäten auf der Rückseite des Substrats und Herstellung der magnetischen 3D-Mikrostrukturen kann nach Fertigstellung der integrierten Schaltung erfolgen.

Die Herstellung der magnetischen 3D-Mikrstrukturen durch Agglomeration µm-großer Partikel eines hart- oder weichmagnetischen Pulvermaterials kann mittels Atomlagenabscheidung erfolgen.

Hierfür wird die Verwendung eines Pulvermaterials mit einer speziellen Größenverteilung vorgeschlagen, um die Fülldichte der Mikromagnete zu erhöhen und dadurch deren Remanenz zu steigern.

Außerdem wird die Verwendung von Gemischen aus unterschiedlichen Pulvermaterialien vorgeschlagen, um die magnetischen Eigenschaften der Mikromagnete anzupassen.

Außerdem wird eine Kombination weichmagnetischer und hartmagnetischer 3D-Mikrostrukturen vorgeschlagen, die unmittelbar benachbart bzw. einem Magnetfeldsensor zugeordnet sind, um das Magnetfeld im Sensorbereich bzw. im Bereich des Targets zu formen.

Die oben beschriebenen Ausführungsbeispiele stellen lediglich eine Veranschaulichung der Prinzipien des hierin beschriebenen innovativen Konzepts dar. Es versteht sich, dass Modifikationen und Variationen der hierin beschriebenen Anordnungen und Einzelheiten anderen Fachleuten einleuchten werden. Deshalb ist beabsichtigt, dass das hierin beschriebene Konzept lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar.

### Quellen

[1] https://www.rutronik.com/suppliers/infineon/3d-magnetic-sensors/
[2] https://www.allegromicro.com/en/Insights-and-Innovations/Technical-Documents/Hall-Effect-Sensor-IC-Publications/AN296157-ATS344-Magnetically-Back-Biased-Differential-Linear-Sensor-IC
[3] file:///C:/Daten/Home%20Lisec/Patente/Partikel+ALD/15%20-%201 ntegriertes%20BackBias%20f%C3% BCr%20Hall-Sensoren%20IIS/Literatur/Allegro%20ATS344-Datasheet.pdf
[4] https://audemars.com/micro-magnets-manufacturing/
[5] T. Lisec, O. Behrmann, B. Gojdka, "PowderMEMS - A generic microfabrication technology for integrated three-dimensional functional microstructures", Micromachines 2022, 13(3)
[6] M.T. Bodduluri, T. Lisec, L. Blohm, F. Lofink, B. Wagner, "High-performance integrated hard magnets for MEMS applications", Proceedings of MikroSystemTechnik Kongress 2019, Berlin, 28.-30. October 2019
[7] T. Lisec et al., "Integrated high power micro magnets for MEMS sensors and actuators. Proceedings of Transducers 2019, Berlin, Germany, 23.-27. June 2019
[8] T.-S. Yang et al., "Fabrication and characterization of parylene-bonded Nd-Fe-B powder micromagnets", J. Appl. Phys. 109, 07A753 (2011); doi: 10.1063/1.3566001

## Patentansprüche

1. Verfahren zum Herstellen eines Magnetfeldsensorchips (200) mit einem integrierten Back-Bias Magneten (140), wobei das Verfahren folgende Schritte aufweist:
Bereitstellen eines Substrats (100) mit einer ersten Substratoberfläche (101) und einer gegenüberliegenden zweiten Substratoberfläche (102),
Anordnen von mindestens einem Magnetfeldsensor (110) auf der ersten Substratoberfläche (101),
Strukturieren von mindestens einer ersten Kavität (120) in der zweiten Substratoberfläche (102),
Erzeugen des integrierten Back-Bias Magneten (140) innerhalb der ersten Kavität (120) durch Einbringen von, magnetisches Material aufweisendem, losem Pulver (160) in die erste Kavität (102) und Agglomerieren des Pulvers (160) zu einer mechanisch festen Magnetkörperstruktur mittels Atomlagenabscheidung,
wobei der Schritt des Erzeugens des Back-Bias Magneten (140) zeitlich nach dem Schritt des Anordnens des Magnetfeldsensors (110) ausgeführt wird.

2. Verfahren nach Anspruch 1,
wobei der Schritt des Strukturierens der ersten Kavität (120) beinhaltet, dass die erste Kavität (120) gegenüber von einem aktiven Sensorbereich des Magnetfeldsensors (110) erzeugt wird, sodass letztlich auch der in der ersten Kavität (110) erzeugte Back-Bias Magnet (140) dem aktiven Sensorbereich gegenüberliegt.

3. Verfahren nach Anspruch 1,
wobei der Schritt des Strukturierens der ersten Kavität (120) beinhaltet, dass die erste Kavität (120) in Form einer Grabenstruktur in das Substrat (100) strukturiert wird,
wobei sich diese Grabenstruktur, in einer Draufsicht auf eine der beiden Substratoberflächen (101, 102), um einen aktiven Sensorbereich des Magnetfeldsensors (110) herum erstreckt, sodass sich letztlich auch der in der ersten Kavität (120) erzeugte Back-Bias Magnet (140) um den aktiven Sensorbereich herum erstreckt.

4. Verfahren nach Anspruch 3,
wobei die erste Kavität (120) in Form einer, in sich geschlossenen, ringförmigen Grabenstruktur erzeugt wird, die sich vollumfänglich um den aktiven Sensorbereich herum erstreckt.

5. Verfahren nach Anspruch 3 oder 4, ferner aufweisend:
Strukturieren einer zusätzlichen Kavität (121) in die zweite Substratoberfläche (102), sodass diese zusätzliche Kavität (121) dem aktiven Sensorbereich des Magnetfeldsensors (110) gegenüberliegt und, in einer Draufsicht auf eine der beiden Substratoberflächen (101, 102), von der ersten Kavität (120) umringt wird, und
Befüllen der zusätzlichen Kavität (121) mit einem magnetischen Material.

6. Verfahren nach Anspruch 5
wobei der Schritt des Befüllens der zusätzlichen Kavität (121) mit dem magnetischen Material beinhaltet, dass das magnetische Material in Form eines losen Pulvers (160) in die zusätzliche Kavität (121) eingefüllt wird, und wobei das Verfahren ferner aufweist:
Agglomerieren des Pulvers (160) zu einer mechanisch festen Mikrokörperstruktur (141) mittels Atomlagenabscheidung.

7. Verfahren nach einem der Ansprüche 5 oder 6,
wobei das in die zusätzliche Kavität (121) einzufüllende lose Pulver (160) zu einem Großteil, d.h. zu über 50%, aus einem weichmagnetischen Material besteht.

8. Verfahren nach einem der vorhergehenden Ansprüche,
wobei das in die erste Kavität (120) einzufüllende lose Pulver (160) zu einem Großteil, d.h. zu über 50%, aus einem hartmagnetischen Material besteht.

9. Verfahren nach einem der vorhergehenden Ansprüche,
wobei das in die erste Kavität (110) einzufüllende lose Pulver (160) ein Gemisch aus Partikeln (161) unterschiedlicher Größe mit einem Größenverhältnis von mindestens 1:10 aufweist.

10. Verfahren nach einem der vorhergehenden Ansprüche,
wobei der Magnetfeldsensor (110) als ein Hallsensor ausgestaltet ist, oder
wobei der Magnetfeldsensor (110) als ein magnetoresistiver Sensor ausgestaltet ist.

11. Verfahren nach einem der vorhergehenden Ansprüche,
wobei die erste Kavität (120) derart erzeugt wird, dass sie eine laterale Ausdehnung (190) zwischen 25 µm und 2000 µm aufweist, sodass der darin erzeugte Back-Bias Magnet (140) als ein Mikromagnet ausgestaltet ist, der eine Strukturbreite (190) zwischen 25 µm und 2000 µm aufweist.

12. Verfahren nach einem der vorhergehenden Ansprüche, ferner aufweisend:
Strukturieren von mindestens einer zweiten Kavität (220) in der zweiten Substratoberfläche (102), und Erzeugen von mindestens einem zweiten Back-Bias Magneten (240) in dieser zweiten Kavität (220),
wobei die erste Kavität (120) und die zweite Kavität (220) mittels eines zeitgesteuerten Ätzprozesses erzeugt werden, wobei die Ätzrate prozessbedingt schwankt, sodass die strukturierten Kavitäten (120, 220) jeweils unterschiedliche Aspektverhältnisse aufweisen, was dazu führt, dass die darin jeweils erzeugten Back-Bias Magnete (120, 220) unterschiedliche Magnetfeldcharakteristiken aufweisen,
wobei das Verfahren ferner beinhaltet:
Bereitstellen einer Kompensationsschaltung (300), die dazu ausgestaltet ist, um den Magnetfeldsensorchip (200) derart anzusteuern, dass Messabweichungen, die auf die prozessbedingten unterschiedlichen Magnetfeldcharakteristiken zurückzuführen sind, kompensiert werden.

13. Verfahren nach einem der vorhergehenden Ansprüche, ferner aufweisend:
Anordnen einer Vielzahl von Magnetfeldsensoren (110, 210) auf der ersten Substratoberfläche (101), und Erzeugen einer Vielzahl von integrierten Back-Bias Magneten (140, 240, 340) in einer entsprechenden Vielzahl von strukturierten Kavitäten (120, 220, 320),
wobei jedem Magnetfeldsensor (110, 210) mindestens ein integrierter Back-Bias Magnet (140, 240, 340) zugeordnet ist.

14. Verfahren nach einem der vorhergehenden Ansprüche,
wobei das Verfahren auf Wafer-Ebene durchgeführt wird und das bereitgestellte Substrat (100) ein Wafer ist, und wobei der Magnetfeldsensorchip (200) durch Vereinzeln aus dem Wafer erhalten wird.

15. Magnetfeldsensorchip (200) mit integriertem Back-Bias Magnet (140), hergestellt unter Anwendung eines Verfahrens gemäß einem der vorhergehenden Ansprüche.
